# EUROPEAN PATENT APPLICATION

(11) **EP 4 693 379 A1**
(43) Date of publication of application: **11.02.2026**
(21) Application number: 23930858.8
(22) Date of filing: 27.11.2023
(51) Int. Cl.: H01L 21/56, B29B 9/08, B29C 33/12, B29C 43/36

(54) **APPARATUS AND METHOD FOR FORMING SEALING RESIN TO BE USED FOR COMPRESSION MOLDING**

(30) Priority: 27.03.2023 JP 2023050308
(71) Applicant: Yamaha Robotics Co., Ltd., Musashimurayama-shi, Tokyo 208-8585 (JP)
(72) Inventor: WAKUI, Masaaki, Chikuma-shi, Nagano 389-0898 (JP); SAITO, Takashi, Chikuma-shi, Nagano 389-0898 (JP); KAWAGUCHI, Makoto, Chikuma-shi, Nagano 389-0898 (JP); NOMURA, Yudai, Chikuma-shi, Nagano 389-0898 (JP)
(74) Representative: Becker, Eberhard
(86) International application number: PCT/JP2023/042283
(87) International publication number: WO 2024/202232

(57) **Abstract**

The present invention addresses the problem of providing an apparatus and a method for forming a sealing resin with which it is possible to achieve a compression molding device and a compression molding method capable of preventing the occurrence of molding defects. As a solution, an apparatus (100) for forming a sealing resin according to the present invention, which forms by tableting a base resin (Rm) a sealing resin (R) to be used for compression molding of a workpiece (W), comprises a tablet mold (102) that accommodates a predetermined amount of the base resin (Rm) in one or both of a pair of a lower mold (106) and an upper mold (104) subjected to mold opening/closing, and that performs tableting so as to form the sealing resin (R) into a predetermined shape corresponding to the shape of the workpiece (W).

## Description

### Technical Field

The present invention relates to a forming apparatus and a forming method of a sealing resin to be used in compression molding.

### Background Art

As an example of a resin sealing apparatus and a resin sealing method that seal, with a sealing resin, a workpiece mounted with an electronic component on a substrate to process into a molded product, a resin sealing apparatus and a resin sealing method based on compression molding are known.

Compression molding is a technique for performing resin sealing by supplying a particular amount of a sealing resin to a sealing region (cavity) provided in a sealing mold configured to include an upper mold and a lower mold, placing a workpiece in the sealing region, and clamping with the upper mold and the lower mold. As an example, in the case of using a sealing mold with a cavity provided in the upper mold, a technique of collectively supplying a sealing resin to a central position on the workpiece to perform molding is known. On the other hand, in the case of using a sealing mold with a cavity provided in the lower mold, a technique of supplying a release film (hereinafter, may be simply referred to as "film") covering a mold surface including the cavity and a sealing resin to perform molding is known (Patent Document 1: see publication of Japanese Patent Application Laid-Open No. 2019-145550).

### Related Art Documents

### Patent Documents

Patent Document 1: publication of Japanese Patent Application Laid-Open No. 2019-145550

### SUMMARY OF INVENTION

### Problem to Be Solved by Invention

For example, in the case of performing resin sealing on a strip-type electronic component (semiconductor chip) connected with wires as the workpiece, in compression molding in which the cavity is provided in the upper mold, there is a problem that resin sealing is difficult because the wire portion of the workpiece held on the lower mold contacts the sealing resin supplied in advance to the cavity or the sealing resin supplied onto the workpiece and is deformed. Thus, generally, in the compression molding adopted, the workpiece is held on the upper mold, the cavity is provided in the lower mold, and the sealing resin (as an example, a granular resin) is supplied into the cavity.

However, in a configuration in which the workpiece is held on the upper mold and the cavity is provided in the lower mold, there is a problem that, in the case of a thin or large workpiece, holding at the upper mold is difficult and dropping is likely to occur. In addition, generally, the sealing resin is supplied into the cavity of the lower mold with a film interposed between, but if a thick molded product with a thickness (herein, thickness of the resin portion after molding) exceeding about 1 mm is to be formed, there are problems that a molding stroke becomes large, and molding defects of the film biting into the molded product are likely to occur. Furthermore, in the case of using a granular resin as the sealing resin, the film biting described above is likely to occur, and in addition to problems of dust generation and difficult handling, there is a problem that it is difficult to supply (scatter) the sealing resin uniformly to the whole region within the cavity provided in the lower mold, and scattering unevenness is likely to occur. In addition, there is a problem that the following molding defects are likely to occur: air contained in gaps between particles during scattering of the sealing resin and gas components due to defoaming with the sealing resin during melting do not escape but remain in the molded product. Particularly, in the case of a workpiece with an electronic component mounted by wire connection, there is also a possibility that wire flow (deformation and cut-off of wires) due to resin flow within the cavity during resin sealing might occur.

### Means for Solving Problem

The present invention has been made in view of the above circumstances, and an objective thereof is to provide a forming apparatus and a forming method forming a sealing resin that is easy to handle, and capable of realizing a compression molding apparatus and a compression molding method making it possible to solve problems of a configuration with a cavity provided in an upper mold and solve problems of a configuration with a cavity provided in a lower mold, prevent occurrence of molding defects due to resin flow, scattering unevenness, residual gas, and dust generation during molding, and form a molded product having a large thickness dimension.

The present invention solves the above problems by means as described below as an embodiment.

A forming apparatus of a sealing resin according to an embodiment is a forming apparatus that tablets a base resin to form a sealing resin to be used for compression molding of a workpiece, and includes, as a requirement, a tableting mold that accommodates a particular amount of the base resin in one or both of a pair of a lower mold and an upper mold subjected to mold opening and closing, and tablets the base resin to form the sealing resin having a particular shape corresponding to a shape of the workpiece. For example, as the workpiece, a workpiece having a configuration in which an electronic component is mounted on a substrate is used.

In addition, it is preferable to include: a lower mold film supply part that supplies a release film to be adsorbed to a mold surface of the lower mold; and an upper mold film supply part that supplies a release film to be adsorbed to a mold surface of the upper mold.

In addition, regarding the workpiece, the particular shape is preferably a shape that does not abut against the electronic component upon placing the sealing resin onto the substrate, and the particular amount is preferably an amount set by measuring a count of presence or absence of the electronic component mounted on one substrate for each workpiece to calculate a resin amount required, or is an amount set by selecting from multiple types of standard amounts corresponding to a type of the workpiece.

In addition, a powder resin is preferably used as the base resin.

In addition, a forming method of a sealing resin according to an embodiment tablets a base resin to form a sealing resin to be used for compression molding of a workpiece, and includes, as a requirement, a tableting process of accommodating and tableting a particular amount of the base resin in a tableting mold, and forming the sealing resin having a particular shape corresponding to a shape of the workpiece.

### Effects of Invention

By using the sealing resin formed by the forming apparatus and the forming method according to the present invention, a compression molding apparatus and a compression molding method can be realized to make it possible to solve problems of a configuration with a cavity provided in an upper mold and solve problems of a configuration with a cavity provided in a lower mold, prevent occurrence of molding defects caused by resin flow, scattering unevenness, residual gas, and dust generation during molding, and form a molded product having a large thickness dimension. In addition, handling becomes easy particularly during supply and during setting compared to the case of a granular resin and the like.

### BRIEF DESCRIPTION OF THE DRAWINGS

[FIG. **1]** FIG. 1 is a plan view showing an example of a compression molding apparatus in which a sealing resin formed by a forming apparatus and a forming method according to an embodiment of the present invention is used.
[FIG. 2] FIG. 2 is a view illustrating an example of a compression molding method in which the sealing resin formed by the forming apparatus and the forming method according to the embodiment of the present invention is used.
[FIG. 3] FIG. 3 is a view continuing from FIG. 2.
[FIG. 4] FIG. 4 is a view continuing from FIG. 3.
[FIG. 5] FIG. 5 is a view illustrating another example of the compression molding method in which the sealing resin formed by the forming apparatus and the forming method according to the embodiment of the present invention is used.
[FIG. 6] FIG. 6 is a view continuing from FIG. 5.
[FIG. 7] FIG. 7 is a view continuing from FIG. 6.
[FIG. 8] FIG. 8 is a side view showing an example of the forming apparatus of a sealing resin according to the embodiment of the present invention.
[FIG. 9] FIG. 9 is a front cross-sectional view showing an example of a tableting mold of the forming apparatus shown in FIG. 8.
[FIG. 10] FIG. 10 is a view illustrating the forming method of a sealing resin according to the embodiment of the present invention.
[FIG. 11] FIG. 11 is a view continuing from FIG. 10.
[FIG. 12] FIG. 12 is a view continuing from FIG. 11.
[FIG. 13] FIG. 13 is a perspective view showing an example of the sealing resin formed by the forming apparatus and the forming method according to the embodiment of the present invention.
[FIG. 14] FIG. 14 is a perspective view showing another example of the sealing resin formed by the forming apparatus and the forming method according to the embodiment of the present invention.
[FIG. 15] FIG. 15 is a perspective view showing another example of the sealing resin formed by the forming apparatus and the forming method according to the embodiment of the present invention.
[FIG. 16] FIG. 16 is a perspective view showing another example of the sealing resin formed by the forming apparatus and the forming method according to the embodiment of the present invention.
[FIG. 17] FIG. 17A is an enlarged view of part A in FIG. 2. FIG. 17B is a view continuing from FIG. 17A.
[FIG. 18] FIG. 18 is a view illustrating a conventional compression molding method.
[FIG. 19] FIG. 19 is a view illustrating a conventional compression molding method.
[FIG. 20] FIG. 20 is a front cross-sectional view showing another example of the tableting mold of the forming apparatus according to the embodiment of the present invention.

### EMBODIMENTS FOR IMPLEMENTING INVENTION

### (Compression molding apparatus and compression molding method)

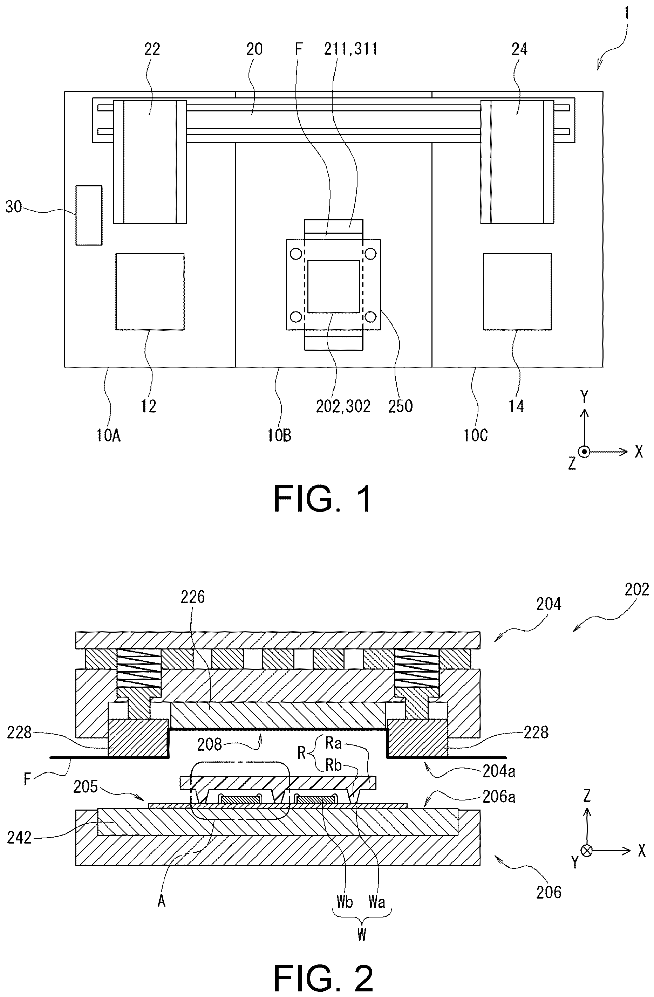

A forming apparatus and a forming method of a sealing resin according to an embodiment of the present invention are an apparatus and a method forming a sealing resin R to be used for compression molding of a workpiece W. First, an outline of a compression molding apparatus 1 and a compression molding method that perform resin sealing (compression molding) of the workpiece W using the sealing resin R will be described. Herein, FIG. 1 is a plan view (schematic view) showing an example of the compression molding apparatus 1.

The workpiece W, which is a sealing target, includes a configuration in which an electronic component Wb is mounted on a substrate Wa. More specifically, examples of the substrate Wa include plate-shaped members such as a resin substrate, a ceramic substrate, a metal substrate, a carrier plate, a lead frame, a wafer, etc. In addition, examples of the electronic component Wb include a semiconductor chip, a MEMS chip, a passive element, a heat dissipation plate, a conductive member, a spacer, etc. The shape of the substrate Wa is rectangular (strip-shaped), square, circular, etc. In addition, the number of electronic components Wb mounted on one substrate Wa is set to one or multiple (e.g., in a matrix pattern and the like).

Examples of a method of mounting the electronic component Wb onto the substrate Wa include methods according to wire bonding mounting, flip chip mounting, etc. Alternatively, in the case of a configuration in which the substrate (carrier plate made of glass or metal) Wa is peeled off from a molded product Wp after resin sealing, there is also a method of attaching the electronic component Wb using an adhesive tape having thermal peelability or an ultraviolet curable resin that cures by ultraviolet irradiation.

In addition, as examples of a film F, film materials excellent in heat resistance, easy peelability, flexibility, and extensibility are suitably used, such as PTFE (polytetrafluoroethylene), ETFE (polytetrafluoroethylene polymer), PET, FEP, fluorine-impregnated glass cloth, polypropylene, polyvinylidene chloride, etc. The film F is also used when forming the sealing resin R in a forming apparatus 100 to be described later.

As shown in FIG. 1, the compression molding apparatus 1 includes, as main components, a supply unit 10A performing supply of the workpiece W and the like, a press unit 10B performing resin sealing of the workpiece W to process into a molded product Wp and the like, and a storage unit 10C performing storage of the molded product Wp and the like. As an example, the supply unit 10A, the press unit 10B, and the storage unit 10C are disposed sequentially along the X-direction in FIG. 1. However, the embodiment is not limited to the above configuration, and the equipment configuration within the units, the number of units (particularly, the number of press units), the arrangement sequence of the units, etc. may be changed. In addition, the embodiment may also have a configuration including units other than the above (all not shown).

In addition, in the compression molding apparatus 1, a guide rail 20 is provided linearly across the units, and a transport apparatus (first loader) 22 transporting the workpiece W and the sealing resin R and a transport apparatus (second loader) 24 transporting the molded product Wp (may also be used for transporting the sealing resin R) are provided to be movable between particular units along the guide rail 20. However, the embodiment is not limited to the above configuration, and may also have a configuration including a common (one) transport apparatus (loader) transporting the workpiece W, the sealing resin R, and the molded product Wp (not shown). In addition, the transport apparatus may also be a configuration including a robot hand or the like instead of a loader.

In addition, the compression molding apparatus 1 includes a control part 30 disposed in the supply unit 10A (may also be configured to be disposed in another unit) to perform operation control of each mechanism in each unit.

The press unit 10B includes a pair of sealing molds opened and closed by a press apparatus 250. As an example, the sealing mold may have a configuration (sealing mold 202) in which a cavity is provided in an upper mold, or, as another example, the sealing mold may have a configuration (sealing mold 302) in which a cavity is provided in a lower mold. In addition, the press apparatus 250 is provided with a film supply part 211 supplying a film F for covering a mold surface 204a (particular region) including an inner surface of a cavity 208 in an upper mold 204. As an example, the film F is in a roll shape, but may also be in a strip shape.

As an example, processes of a compression molding method implemented using the compression molding apparatus 1 in the case of including the sealing mold 202 will be described with reference to FIG. 2 to FIG. 4.

First, a preparation process (sealing preparation process) is implemented. Specifically, a process is implemented to adjust and heat an upper mold 204 and a lower mold 206 to a particular temperature (e.g., 100°C to 300°C). In addition, a process is implemented to operate the film supply part 211 to supply a new film F, and adsorb the film F to cover a particular region of the mold surface 204a including an inner surface of the cavity 208 in the upper mold 204.

After the preparation process, a workpiece holding process is implemented to cause a workpiece W to be held onto a workpiece holding part 205 of the lower mold 206. Specifically, the workpiece W supplied from a supply magazine 12 is held by the first loader 22 and carried into the sealing mold 202, and is caused to be held onto the workpiece holding part 205 of a lower plate 242 (mold surface 206a).

After the workpiece holding process, a resin placement process is implemented to place a sealing resin R onto the workpiece W held on the workpiece holding part 205 (see FIG. 2). Specifically, the sealing resin R formed in a forming apparatus 100 of a sealing resin (may be simply referred to as "forming apparatus") to be described later is held by the first loader 22 (may also be another transport apparatus) and carried into the sealing mold 202, and is placed onto the workpiece W held on the workpiece holding part 205.

Alternatively, as another example of the resin placement process, a process may also be implemented to place the sealing resin R formed in the forming apparatus 100 onto the workpiece W before the above workpiece holding process. In that case, the workpiece holding process becomes a process of causing the workpiece W with the sealing resin R placed thereon to be held onto the workpiece holding part 205. That is, the first loader 22 holds the workpiece W with the sealing resin R placed thereon to carry the workpiece W into the sealing mold 202, and causes the workpiece W to be held onto the workpiece holding part 205. There is an advantage of performing carry-in of the workpiece W and the sealing resin R into the sealing mold 202 in one operation instead of performing the carry-in separately.

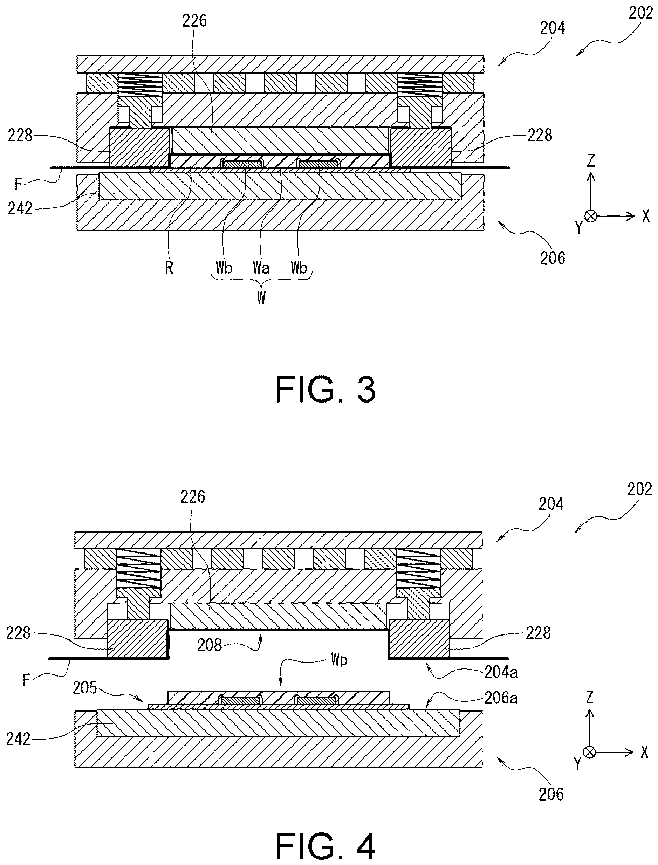

Next, a resin sealing process is implemented to seal the workpiece W with the sealing resin R to process into a molded product Wp. Specifically, a mold closing process is implemented to perform mold closing of the sealing mold 202, relatively lower a cavity piece 226 within the cavity 208 surrounded by a clamper 228, and heat and pressurize the sealing resin R against the workpiece W. Accordingly, the sealing resin R is thermally cured, and resin sealing (compression molding) is completed (see FIG. 3).

The processes following the above mold closing process are similar to those in a conventional compression molding method. As an outline, a mold opening process is implemented to perform mold opening of the sealing mold 202, and separate the molded product Wp and the used film F to enable the molded product Wp to be taken out (see FIG. 4). Next, a molded product carry-out process is implemented to carry the molded product Wp out of the sealing mold 202 by the second loader 24, and transport to the storage unit 10C. As an example, the transported molded product Wp is stored in a storage magazine 14. In addition, after the molded product carry-out process, or in parallel to the molded product carry-out process, a process is implemented to operate the film supply part 211 to send the used film F out of the sealing mold 202, and send and set a new film F into the sealing mold 202.

The above are the main processes of the compression molding method performed using the compression molding apparatus 1 in the case of including the sealing mold 202. However, the above process sequence is an example, and changes in the order or parallel implementation is possible as long as there is no hindrance.

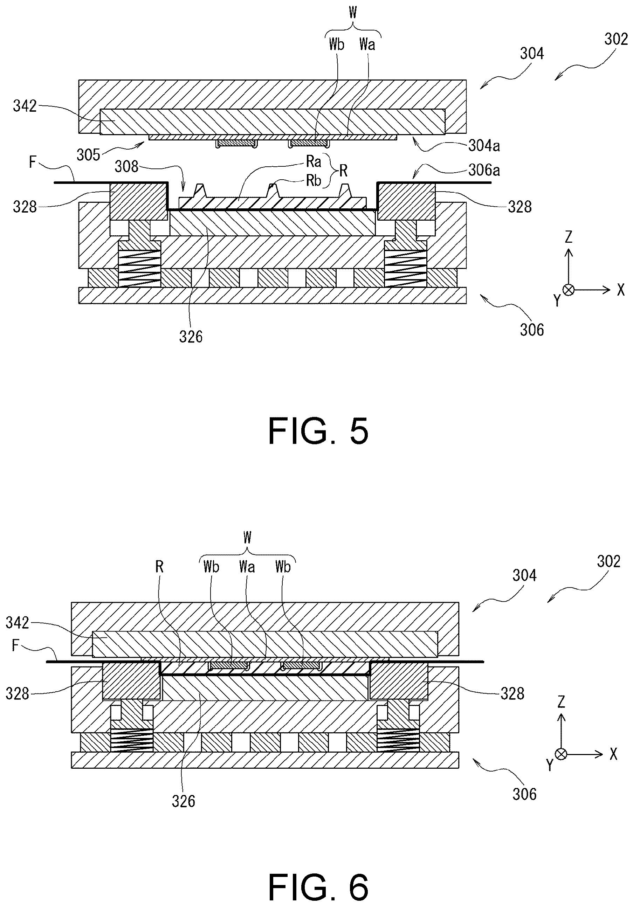

As another example, processes of a compression molding method implemented using the compression molding apparatus 1 in the case of including the sealing mold 302 will be described with reference to FIG. 5 to FIG. 7. In this case, the press apparatus 250 is provided with a film supply part 311 supplying a film F for covering a mold surface 306a (particular region) including an inner surface of a cavity 308 in a lower mold 306. As an example, the film F is in a roll shape, but may also be in a strip shape.

First, a preparation process (sealing preparation process) is implemented. Specifically, a process is implemented to adjust and heat an upper mold 304 and a lower mold 306 to a particular temperature (e.g., 100°C to 300°C). In addition, a process is implemented to operate the film supply part 311 to supply a new film F, and adsorb the film F to cover a particular region of the mold surface 306a including an inner surface of the cavity 308 in the lower mold 306.

After the preparation process, a workpiece holding process is implemented to cause a workpiece W to be held onto a workpiece holding part 305 of the upper mold 304. Specifically, the workpiece W supplied from the supply magazine 12 is held by the first loader 22 and carried into the sealing mold 302, and is caused to be held onto the workpiece holding part 305 of an upper plate 342 (mold surface 304a).

After the workpiece holding process, a resin holding process is implemented (may also be implemented before the workpiece holding process or in parallel to the workpiece holding process). The resin holding process includes the following process. The sealing resin R is held within the cavity 308 of the lower mold 306 (see FIG. 5). Specifically, the sealing resin R formed in the forming apparatus 100 is held by the first loader 22 (may also be another transport apparatus) and carried into the sealing mold 302, and is accommodated within the cavity 308 (specifically, placed on an upper surface of a cavity piece 326).

Next, a resin sealing process is implemented to seal the workpiece W with the sealing resin R to process into a molded product Wp. Specifically, a mold closing process is implemented to perform mold closing of the sealing mold 302, relatively raise the cavity piece 326 within the cavity 308 surrounded by a clamper 328, and heat and pressurize the sealing resin R against the workpiece W. Accordingly, the sealing resin R is thermally cured and resin sealing (compression molding) is completed (see FIG. 6).

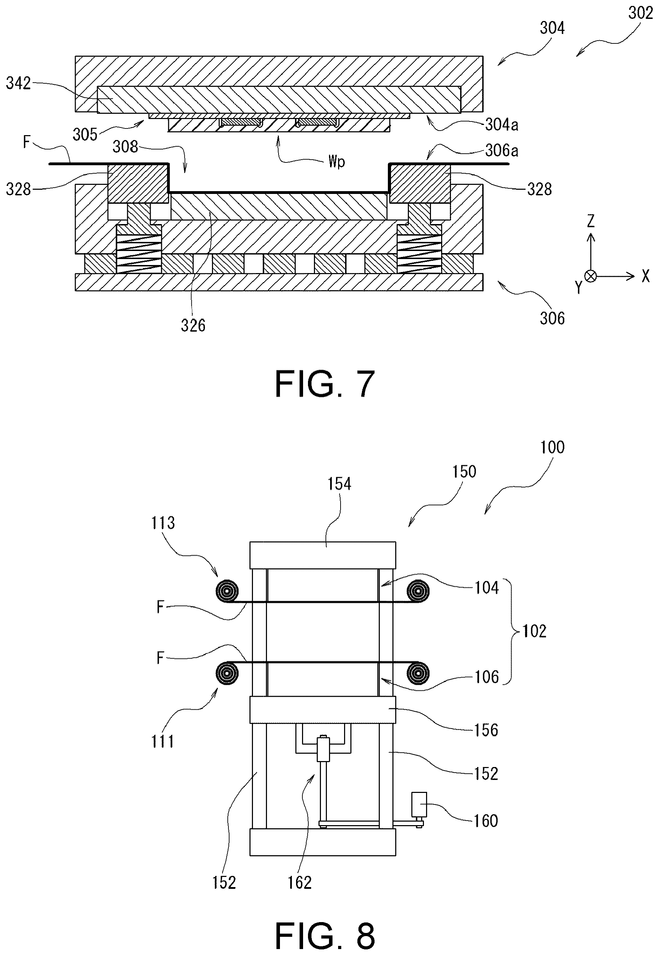

The processes following the above mold closing process are similar to those in a conventional compression molding method. As an outline, a mold opening process is implemented to perform mold opening of the sealing mold 302, and separate the molded product Wp and the used film F to enable the molded product Wp to be taken out (see FIG. 7). Next, a molded product carry-out process is implemented to carry the molded product Wp out of the sealing mold 302 by the second loader 24, and transport to the storage unit 10C. As an example, the transported molded product Wp is stored in the storage magazine 14. In addition, after the molded product carry-out process, or in parallel to the molded product carry-out process, a process is implemented to operate the film supply part 311 to send the used film F out of the sealing mold 302, and send and set a new film F into the sealing mold 302.

The above are the main processes of the compression molding method performed using the compression molding apparatus 1 in the case of including the sealing mold 302. However, the above process sequence is an example, and changes in the order or parallel implementation is possible as long as there is no hindrance.

### (Forming apparatus of sealing resin)

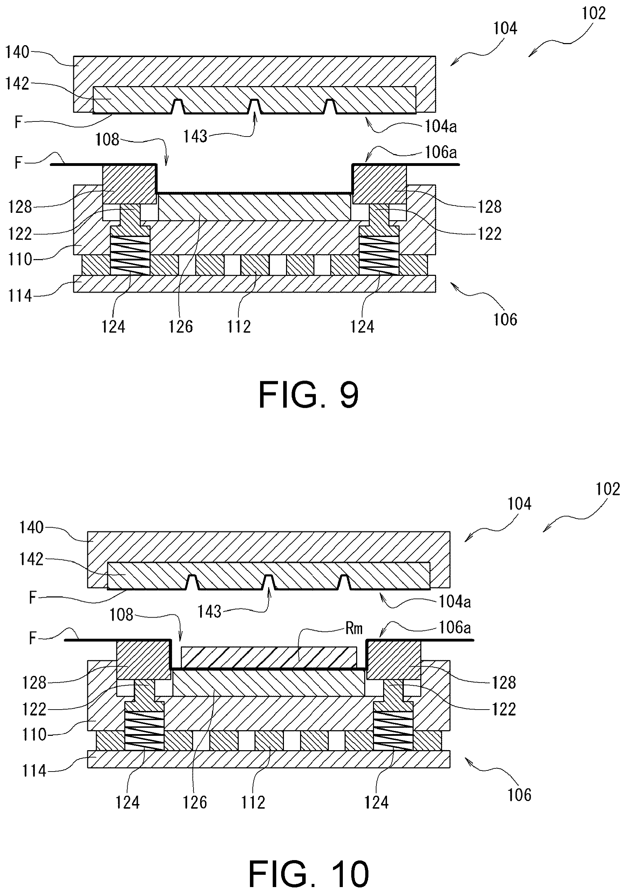

Next, the forming apparatus 100 forming the sealing resin R to be used in the compression molding apparatus 1 and the compression molding method above will be described with reference to FIG. 8 and FIG. 9. The forming apparatus 100 processes a base resin Rm to form the sealing resin R. Herein, FIG. 8 is a side view (schematic view) showing an example of the forming apparatus 100. The forming apparatus 100 may be provided either inside or outside the apparatus of the compression molding apparatus 1.

In the present embodiment, a thermosetting resin (e.g., a filler-containing epoxy-based resin or the like, but not limited thereto) is used as the base resin Rm and the sealing resin R formed from the base resin Rm. The sealing resin R is formed as a solid/semi-solid resin having a particular shape (details will be described later) with an entire shape corresponding to the shape of the workpiece W. Generally, one piece constitutes the "entirety" of the amount required for sealing (one-time amount per workpiece W), but the embodiment may also be configured such that several pieces (e.g., about two or three pieces) in a divided state constitute the "entirety" of the amount required for sealing. In addition, the above "semi-solid" refers to a state that is not a completely solid state but is melted to a so-called B-stage. For the base resin Rm, a powder resin (form) that is a thermosetting resin (property) is suitably used (details will be described later). However, the embodiment is not limited thereto, and a granular resin, a crushed resin, a solid resin, a liquid resin, or a resin combining multiple of these may also be used.

As shown in FIG. 8, the forming apparatus 100 includes a tableting mold 102 having a pair of molds (e.g., obtained by assembling multiple mold blocks made of alloy tool steel, mold plates, mold pillars, or other members) that are subjected to mold opening and closing. In addition, the forming apparatus 100 includes a press apparatus 150 driving the opening and closing of the tableting mold 102. Herein, FIG. 9 is a front cross-sectional view (schematic view) showing an example of the tableting mold 102.

As shown in FIG. 8, the press apparatus 150 includes a pair of platens 154 and 156, multiple tie bars 152 on which the pair of platens 154 and 156 are installed, a drive apparatus causing the platen 156 to be movable (rise and lower), etc. Specifically, the drive apparatus includes a drive source (e.g., electric motor) 160 and a drive transmission mechanism (e.g., ball screw or toggle link mechanism) 162 (however, the embodiment is not limited thereto). In the present embodiment, in the vertical direction, the upper platen 154 is set as a fixed platen (platen fixed to the tie bars 152), and the lower platen 156 is set as a movable platen (platen slidably held by the tie bars 152 to rise and lower). However, the embodiment is not limited thereto, and the upper and lower sides may be reversed, i.e., setting the upper side as the movable platen and the lower side as the fixed platen, or both the upper side and the lower side may be set as movable platens (all not shown).

On the other hand, as shown in FIG. 9, the tableting mold 102 includes an upper mold 104 on the upper side and a lower mold 106 on the lower side in the vertical direction, as a pair of molds disposed between the pair of platens 154 and 156 in the press apparatus 150. The upper mold 104 is assembled to the upper platen (in the present embodiment, the fixed platen 154), and the lower mold 106 is assembled to the lower platen (in the present embodiment, the movable platen 156). With the upper mold 104 and the lower mold 106 approaching and separating from each other, mold closing and mold opening are performed (the vertical direction (up-down direction) serves as the mold opening and closing direction). In the tableting mold 102 according to the present embodiment, the upper mold 104 constitutes a so-called "pestle mold", and the lower mold 106 constitutes a so-called "mortar mold".

Next, the lower mold 106 of the tableting mold 102 will be described in detail. As shown in FIG. 9, the lower mold 106 includes a lower mold chase 110, and a cavity piece 126, a clamper 128, etc. held therein. The lower mold chase 110 is fixed to the upper surface of a support plate 114 via support pillars 112. A cavity 108 is provided on the upper surface of the lower mold 106 (surface on the upper mold 104 side). A particular amount of the base resin Rm is accommodated in the cavity 108.

The clamper 128 is configured in an annular shape to surround the cavity piece 126, and is assembled to be spaced apart (floating) from the upper surface of the support plate 114 and movable up and down via a push pin 122 and a clamper spring 124 (e.g., a biasing member exemplified by a coil spring) (however, the embodiment is not limited to this assembly structure). The cavity piece 126 constitutes a deep part (bottom part) of the cavity 108, and the clamper 128 constitutes a lateral part of the cavity 108. The shape and number of cavities 108 provided in one lower mold 106 are set as appropriate (one or multiple).

Herein, the press apparatus 150 is provided with a lower mold film supply part 111 supplying a film F for covering a mold surface 106a (particular region) including an inner surface of the cavity 108 in the lower mold 106. As an example, the film F is in a roll shape, but may also be in a strip shape.

In addition, the lower mold 106 is provided with suction passages (holes, grooves, etc.) (not shown) that communicate with a suction apparatus, on the upper surface of the clamper 128, at a boundary part between the clamper 128 and the cavity piece 126. Accordingly, the film F supplied from the lower mold film supply part 111 can be adsorbed and held on the mold surface 106a including the inner surface of the cavity 108.

In addition, in the present embodiment, a lower mold heating mechanism (not shown) heating the lower mold 106 to a particular temperature is provided. The lower mold heating mechanism includes a heater (e.g., electric wire heater), a temperature sensor, a power source, etc., and heating control is performed by the control part 30. As an example, the heater is built into the lower mold chase 110 and is configured to apply heat to the entire lower mold 106 and the base resin Rm accommodated in the cavity 108. At this time, the lower mold 106 is heated to a particular temperature (e.g., 50°C to 80°C) at which the base resin Rm does not thermally cure (fully cure).

Next, the upper mold 104 of the tableting mold 102 will be described in detail. As shown in FIG. 9, the upper mold 104 includes a tableting plate 142 that presses a particular amount of the base resin Rm accommodated in the cavity 108 of the lower mold 106 to form (tablet) into a sealing resin R having a particular shape corresponding to the shape of the workpiece W (details of the forming method will be described later). The tableting plate 142 is held (fixed) to an upper mold chase 140. As an example, leg part forming grooves (including recesses) 143 for forming leg parts Rb of the sealing resin R are provided on the lower surface of the tableting plate 142 (surface on the lower mold 106 side).

Herein, the press apparatus 150 is provided with an upper mold film supply part 113 supplying a film F for covering a mold surface 104a (particular region) of the upper mold 104. As an example, the film F is in a roll shape, but may also be in a strip shape.

In addition, the upper mold 104 is provided with suction passages (holes, grooves, etc.) (not shown) that communicate with a suction apparatus, in the tableting plate 142 and the like. Accordingly, the film F supplied from the upper mold film supply part 113 can be adsorbed and held on the mold surface 104a.

In addition, in the present embodiment, an upper mold heating mechanism (not shown) heating the upper mold 104 to a particular temperature is provided. The upper mold heating mechanism includes a heater (e.g., electric wire heater), a temperature sensor, a power source, etc., and heating control is performed by the control part 30. As an example, the heater is built into the upper mold chase 140 and is configured to apply heat to the entire upper mold 104. At this time, the upper mold 104 is heated to a particular temperature (e.g., 50°C to 80°C) at which the base resin Rm held (accommodated) in the lower mold 106 does not thermally cure (fully cure).

### (Forming method of sealing resin)

Next, processes of the forming method of a sealing resin according to the present embodiment implemented using the above forming apparatus 100 will be described. Herein, FIG. 10 to FIG. 12 are views illustrating each process and are shown as front cross-sectional views in the same direction as FIG. 9.

First, a preparation process (tableting preparation process) is implemented. The preparation process includes the following processes. A lower mold heating process is implemented to adjust and heat the lower mold 106 to a particular temperature (temperature at which the base resin Rm and the sealing resin R do not fully cure, e.g., 50°C to 80°C) by the lower mold heating mechanism. In addition, an upper mold heating process is implemented to adjust and heat the upper mold 104 to a particular temperature (temperature at which the base resin Rm and the sealing resin R do not fully cure, e.g., 50°C to 80°C) by the upper mold heating mechanism. In addition, a lower mold film supply process is implemented to operate the lower mold film supply part 111 to supply a new film F and adsorb the film F to cover a particular region of the mold surface 106a including the inner surface of the cavity 108 in the lower mold 106. In addition, an upper mold film supply process is implemented to operate the upper mold film supply part 113 to supply a new film F and adsorb the film F to cover a particular region of the mold surface 104a of the upper mold 104.

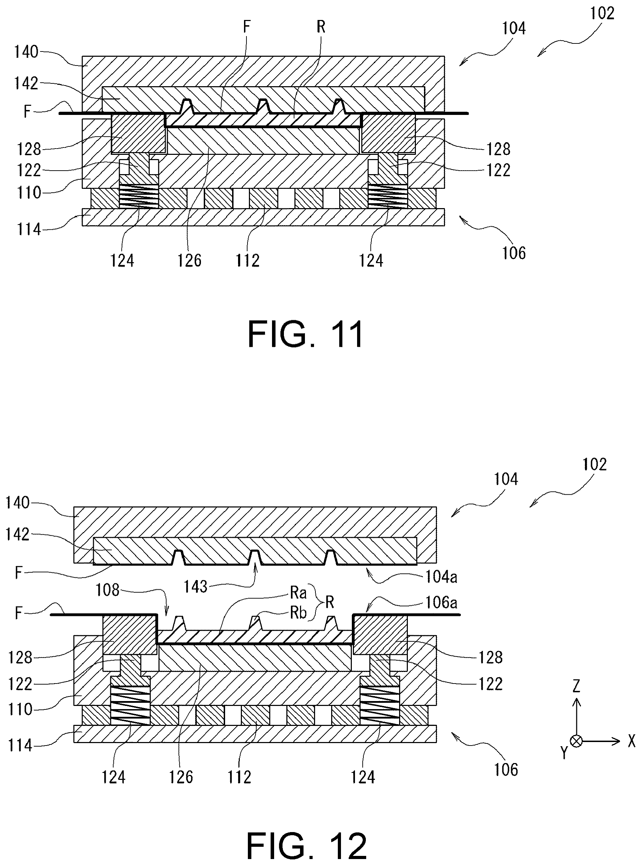

After the preparation process, a tableting process is implemented to tablet the base resin Rm to form, as the sealing resin R, a solid/semi-solid resin having a particular shape (to be described later) with an entire shape corresponding to the shape of the workpiece W. Specifically, a particular amount of the base resin Rm is accommodated in the cavity 108 of the lower mold 106 (see FIG. 10) by a dispenser or the like (not shown). Next, the press apparatus 150 is operated to perform mold closing of the tableting mold 102 heated to the above particular temperature (see FIG. 11). At this time, the cavity piece 126 relatively rises within the cavity 108, and the base resin Rm is tableted (sandwiched and pressurized) by the cavity piece 126 and the tableting plate 142. Accordingly, a solid/semi-solid sealing resin R having a particular shape and in a state of not being thermally cured (fully cured) is formed. At this time, the base resin Rm that enters the leg part forming grooves 143 of the tableting plate 142 with the film F interposed therebetween become leg parts Rb of the sealing resin R, and the other (remaining) base resin Rm becomes a body part Ra of the sealing resin R (the detailed configuration of the sealing resin R will be described later). As a modification example of the tableting process, a part of the particular amount of the base resin Rm may be held (welded, gripped, etc.) on the upper mold 104 (not shown). In addition, although the leg part forming grooves 143 are provided in the tableting plate 142 herein, the leg part forming grooves 143 may also be provided in the cavity piece 126, or may also be provided in both.

It is important that the above tableting process is implemented at a temperature at which the base resin Rm does not thermally cure (fully cure) (implemented by heating the lower mold 106 and the upper mold 104 to a temperature at which thermal curing (full curing) does not occur), such that the formed sealing resin R can thermally cure (fully cure) in the subsequent resin sealing process (which is a process of the compression molding method). As described above, the "temperature at which thermal curing does not occur" depends on the material of the base resin Rm, but as a specific example, is approximately 50°C to 80°C (in the present embodiment, approximately 70°C).

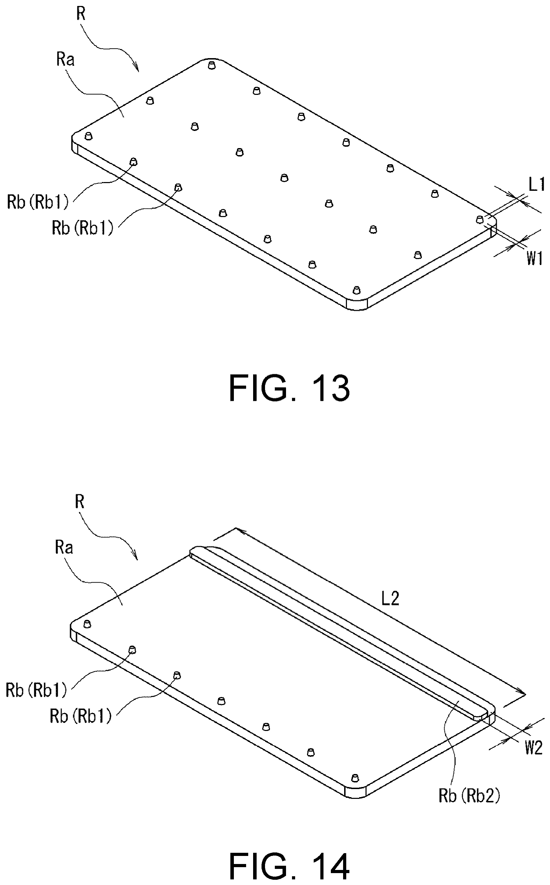

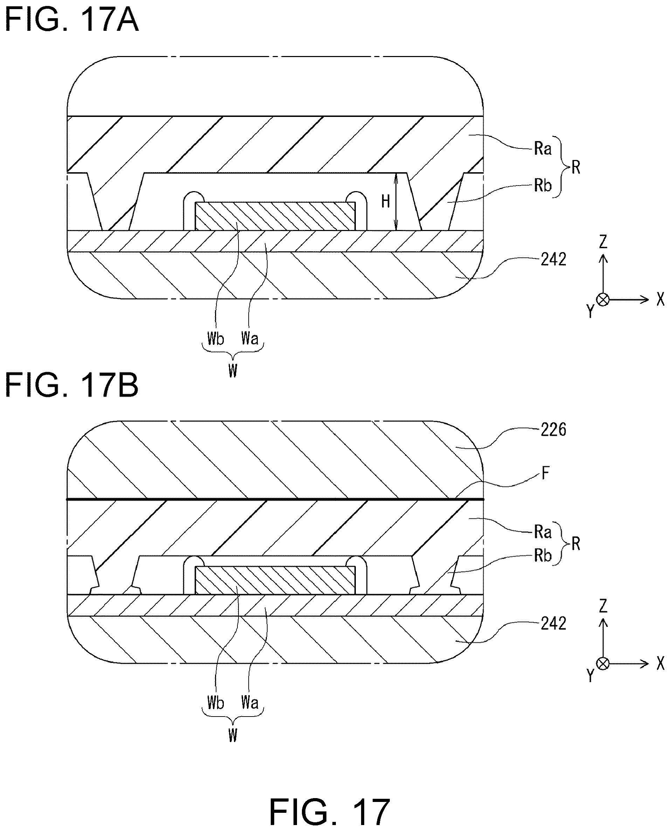

Herein, the "particular shape" of the sealing resin R will be described. As an example, in the case of a sealing resin R to be used in the compression molding apparatus 1 including the sealing mold 202, the "particular shape" is a shape that does not abut against the electronic component Wb (including wires in the case of an electronic component Wb having wires) when placed on the substrate Wa of the workpiece W. As an example, as shown in FIG. 2, the sealing resin R suitably has a shape provided with a plate-shaped or block-shaped body part Ra, and leg parts Rb erected intermittently (or continuously) on one surface of the body part Ra (a surface opposed to the electronic component Wb of the workpiece W) (however, the embodiment is not limited to this shape). The body part Ra has a size that fits within the cavity 208 in a plan view, and considering resin flow, a size slightly smaller than the shape of the cavity 208 (particularly, the cavity piece 226) is suitable. In addition, the leg part Rb requires a height H (see FIG. 17A) that does not abut against the electronic component Wb, but this does not exclude contact to an extent that the wires do not plastically deform. In addition, the leg parts Rb are disposed at positions that do not abut against the electronic component Wb in a plan view of the body part Ra, and at which the body part Ra does not tilt when placed on the substrate Wa of the workpiece W. Furthermore, a configuration disposed between the electronic components Wb or at outer peripheral positions of the electronic component Wb is suitable so as not to damage any wiring (particularly, wires) of the workpiece W during molding. The total resin amount of the plate-shaped or block-shaped body part Ra and the leg parts Rb may be a resin amount without excess or deficiency to an extent that it is not insufficient for one compression molding, or may be a larger resin amount. Details of specific configuration examples (FIG. 13 to FIG. 16) of the sealing resin R will be described later.

As another example, in the case of a sealing resin R to be used in the compression molding apparatus 1 including the sealing mold 302, the "particular shape" is a shape in which the body part Ra of the sealing resin R does not abut against the electronic component Wb (including wires in the case of an electronic component Wb having wires) of the workpiece W, in a state in which the upper mold 304 is gradually brought close to the lower mold 306 and tip parts (upper end parts) of the leg parts Rb of the sealing resin R accommodated in the cavity 308 abut against the substrate Wa of the workpiece W held on the workpiece holding part 305 when performing mold closing of the sealing mold 302. Since the specific shape of the sealing resin R is the same as in the case of the sealing resin R to be used in the compression molding apparatus 1 including the sealing mold 202 described above (see FIG. 17A and FIG. 13 to FIG. 16), repeated descriptions thereof will be omitted. However, the sealing resin R is not limited to the configurations shown in FIG. 17A and FIG. 13 to FIG. 16, and may also have a configuration in which the upper surface is formed to be flat without providing the leg parts Rb on the upper surface (not shown).

Next, a resin amount setting process of setting the "particular amount" of the base resin Rm will be described. As an example of the resin amount setting process, for each workpiece W serving as the sealing target, a count of presence or absence of the electronic component Wb mounted on one substrate Wa (a mounting count or a missing count, and may further include a case of measuring the height of the electronic component Wb) is measured by a measuring mechanism or the like (not shown), and the control part 30 calculates a resin amount (number of grams) required for resin sealing (compression molding) to set the "particular amount", by subtracting the total volume of the electronic components Wb from the volume of the cavity 208 and 308 of the sealing mold 202 and 302. Alternatively, as another example of the resin amount setting process, multiple types of standard amounts corresponding to the type of the workpiece W serving as the sealing target are prepared, and the control part 30 or an operator selects an optimal one according to the type of the workpiece W from among the standard amounts to set the "particular amount". In the case of standard amounts, it is important that the resin amount does not become insufficient during resin sealing (during compression molding). According to either setting, an appropriate amount of the base resin Rm can be supplied for the workpiece W. Thus, particularly, occurrence of molding defects caused by an insufficient resin amount required during resin sealing can be prevented. Furthermore, occurrence of waste caused by supplying an excessive resin amount more than necessary can be prevented.

In addition, suitably, a powder resin is used as the base resin Rm. Accordingly, compared to the case where a granular resin or a crushed resin is used, the "particular amount" of the resin can be supplied with extremely accurate adjustment. However, the embodiment is not limited to the powder resin.

After the tableting process, a mold opening process is implemented to perform mold opening of the tableting mold 102, and separate the sealing resin R and the used film F to enable the sealing resin R to be taken out (see FIG. 12). In the present embodiment, by including the lower mold film supply process and the upper mold film supply process described above, since the film F is disposed on both the mold surface 106a of the lower mold 106 and the mold surface 104a of the upper mold 104, mold release of the sealing resin R formed by tableting becomes easy, and defects due to resin adhesion to the mold can be prevented.

After the mold opening process, or in parallel to the mold opening process, a film supply process (lower mold film supply process, upper mold film supply process) is implemented to operate the lower mold film supply part 111 and the upper mold film supply part 113 to send the used films F out of the tableting mold 102, and send and set new films F into the tableting mold 102.

### (Sealing resin)

Next, specific configuration examples of the sealing resin R formed by the forming apparatus and the forming method described above are shown in FIG. 13 to FIG. 16, and characteristics of each will be described.

First, as a configuration common to each example shown in FIG. 13 to FIG. 16, the body part Ra is formed in a plate shape (may also be in a shape other than a plate shape, e.g., a block shape having recesses or protrusions). In addition, the leg parts Rb are erected on the body part Ra at positions that do not abut against the electronic component Wb of the workpiece W, and are formed to a height H (see FIG. 17A) capable of ensuring a distance with which the body part Ra does not abut against the electronic component Wb, when the sealing resin R is placed at a particular position (setting position in design) on the substrate Wa of the workpiece W. As described above, in the tableting process, the base resin Rm that enters the leg part forming grooves 143 of the tableting plate 142 with the film F interposed therebetween become the leg parts Rb of the sealing resin R, and the other (remaining) base resin Rm becomes the body part Ra of the sealing resin R.

In the example of the sealing resin R shown in FIG. 13, all of (or may be a part of) the leg parts Rb are formed as protrusions Rb1 disposed in a dot pattern. As an example of the protrusion Rb1, the protrusion Rb1 is disposed at multiple positions, and is formed in a shape in which a ratio t of a length L1 to a width W1 in a plan view is, as an example, 0.5 ≤ t ≤ 2. Accordingly, with the configuration in which the leg part Rb is in a columnar shape disposed in a dot pattern, flow of the sealing resin R placed on the workpiece W during compression molding can be suppressed. Thus, wire flow and the like can be prevented, and molding quality can be improved.

In the example of the sealing resin R shown in FIG. 14, a part of (or may be all of) the leg parts Rb is formed as a protrusion Rb2 disposed in a linear shape. As an example of the protrusion Rb2, the protrusion Rb2 is disposed at one position (or may be multiple positions), and is formed in a shape in which a ratio t of a length L2 to a width W2 in a plan view is, as an example, t < 0.5 or 2 < t. Accordingly, resin flow can be intentionally generated from the leg part Rb (in this case, the protrusion Rb2) having a bank-shaped configuration of a particular length to promote filling of the sealing resin R into a narrow part (e.g., between the substrate Wa and the electronic component Wb which are flip-chip connected) in the workpiece W. Thus, gas can be prevented from remaining in the molded product Wp, and molding quality can be improved.

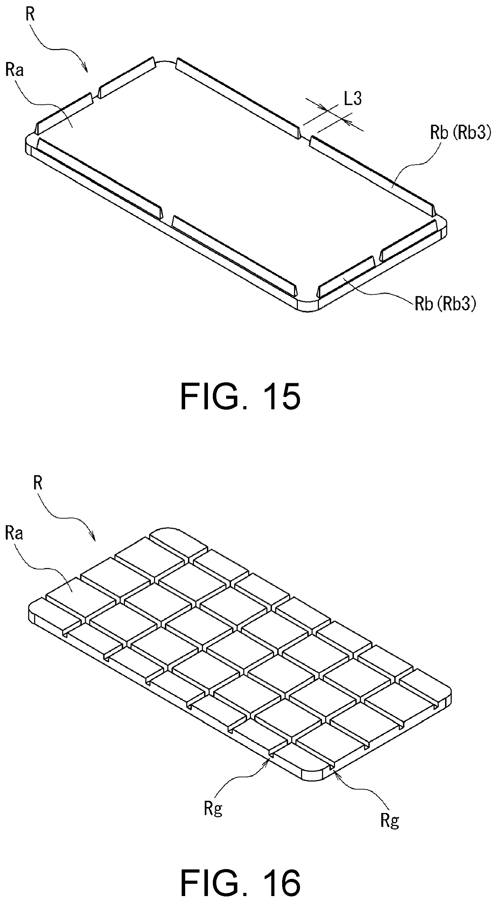

In the example of the sealing resin R shown in FIG. 15, the leg part Rb is formed as protrusions Rb3 disposed to surround intermittently (or may surround continuously) over the entire outer periphery (referring to the outer edge region) (entire perimeter) of the body part Ra. As an example of the protrusion Rb3, protrusions having the same configuration as Rb2 described above are formed in series to form a peripheral shape, with gaps L3 provided at particular intervals. Generally, the outer peripheral position of the sealing resin R in the molded product Wp is a position that is cut off by a dicer or the like during singulation, and since the electronic component Wb is not present, a larger amount of resin is required for sealing compared to the central position. Thus, by providing the leg parts Rb (in this case, the protrusions Rb3) disposed to surround over the entire outer periphery as in this configuration, it becomes possible to supply more resin to the outer peripheral position while suppressing resin flow during compression molding. Furthermore, by providing the gaps L3, discharge of gas components such as air from inside (central part) to outside is promoted.

On the other hand, the example of the sealing resin R shown in FIG. 16 is a configuration example related to the other surface of the body part Ra (the surface on the side where the leg parts Rb are not provided, i.e., the surface on the side that is not opposed to the electronic component Wb of the workpiece W). Specifically, the body part Ra has linear groove parts Rg formed on the other surface at positions at which dicing for singulation is performed. Accordingly, reduction of wearing of the dicing blade and reduction of dust generated during dicing can be achieved. As an example, the groove parts Rg are provided in a lattice pattern matching the dicing positions, but are not limited thereto. To form the groove parts Rg, the tableting process may be implemented using a cavity piece 126 having protrusions (not shown) of corresponding shapes provided on the upper surface.

As described above, by using the sealing resin R formed by the forming apparatus and the forming method according to the present invention, a compression molding apparatus and a compression molding method achieving the following effects can be realized. Specifically, with the compression molding apparatus and the compression molding method, occurrence of molding defects caused by resin flow, scattering unevenness, residual gas, and dust generation during molding can be prevented. In addition, not only thin molded products Wp (thickness dimension less than 1 mm) but thick molded products Wp (thickness dimension equal to or greater than 1 mm) can also be formed. The upper limit of the thickness dimension, although depending on various setting conditions, is considered to be capable of sufficiently forming up to about 10 mm. In addition, handling during supply and during setting becomes easy.

Furthermore, with the compression molding apparatus and the compression molding method, problems that occur in the case of a configuration in which a cavity is provided in the upper mold can be solved. That is, in a conventional compression molding apparatus with a cavity provided in the upper mold, for example, when implementing a mold closing process on a workpiece W or the like mounted with strip-type electronic components (semiconductor chips) Wb connected with wires, the wire portion of the workpiece held on the lower mold comes into contact with the sealing resin supplied in advance to the cavity or the sealing resin supplied onto the workpiece, and is deformed or cut off, which makes resin sealing difficult. To address this problem, a solution can be achieved by adopting a configuration using the sealing resin R formed by the apparatus and the method according to the present embodiment, i.e., a solid/semi-solid resin formed into a particular shape corresponding to the shape of the workpiece W.

Specifically, during the mold closing process, softening and melting of the sealing resin R by heating progresses as transition occurs from FIG. 17A to FIG. 17B (FIG. 17A and FIG. 17B are shown as enlarged views of part A in FIG. 2). At this time, the resin (specifically, the body part Ra) is in a state of uniformly abutting against all wires (see FIG. 17B). Thus, it becomes possible to prevent deformation and cut-off of the wires.

Furthermore, when the inventors of the present application actually conducted experiments using the sealing resin R formed by the apparatus and the method according to the present embodiment in the above compression molding apparatus 1, compared to a conventional compression molding apparatus having a configuration in which the workpiece W is held on the upper mold, a cavity is provided in the lower mold, and the sealing resin (specifically, a granular resin) is supplied to the cavity, results indicating that deformation and cut-off of wires are prevented and molding quality is improved could be confirmed.

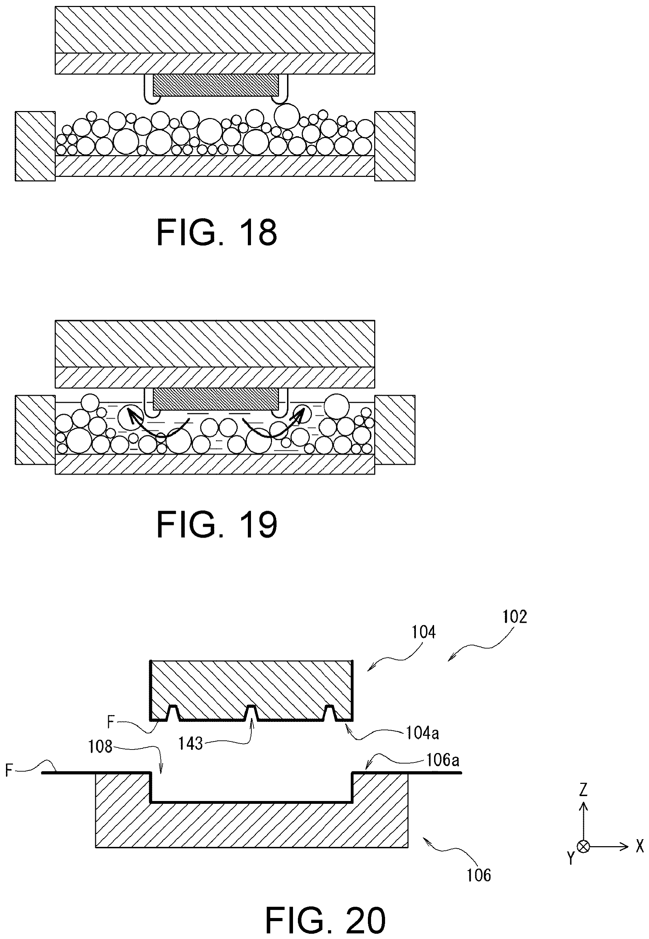

On the other hand, with the compression molding apparatus and the compression molding method, problems that occur in the case of a configuration with the cavity provided in the lower mold can be solved. That is, in a conventional compression molding apparatus with the cavity provided in the lower mold, particularly in the case of using a granular resin as the sealing resin, the particle size and the height (laminating thickness) of the sealing resin (granular resin) accommodated in the cavity are not uniform. Thus, for example, depending on the type and melting state of the granular resin, there may be cases of not completely becoming liquid (low viscosity state), and when implementing a mold closing process on a workpiece W or the like mounted with strip-type electronic components (semiconductor chips) Wb connected with wires, as shown in FIG. 18, depending on the position, there is a problem that the wire portion of the workpiece held on the upper mold partially contacts strongly (largely) against the sealing resin (granular resin) and is deformed or cut off. Furthermore, as shown in FIG. 19, there is a problem that large resin flow occurs within the cavity, and the wire portion is deformed or cut off. To address this problem, a solution can be achieved by adopting a configuration using the sealing resin R formed by the apparatus and the method according to the present embodiment, i.e., a solid/semi-solid resin formed into a particular shape corresponding to the shape of the workpiece W.

Specifically, the reason is the same as described according to FIG. 17A and FIG. 17B above, that is, during the mold closing process, softening and melting of the sealing resin R due to heating progresses, leading to a state in which the resin (specifically, the body part Ra) uniformly abuts against all wires. From this viewpoint, the sealing resin R is not limited to the configurations shown in FIG. 13 to FIG. 16, and may also have a configuration (not shown) in which the upper surface is formed to be flat without providing the leg parts Rb on the upper surface. Even with this configuration, compared to the conventional art using a granular resin, it becomes possible to solve problems caused by non-uniformity in the particle size and the height (laminating thickness). In addition, by configuring the forming apparatus 100 of the sealing resin R and the compression molding apparatus 1 as separate apparatuses, the compression molding apparatus 1 can be configured to be unaffected by dust when tableting the powder resin in the forming apparatus 100, and the compression molding apparatus 1 can be easily placed in a clean room. Further, although the tableting mold 102 of the forming apparatus 100 has a structure including a movable clamper 128 as an example, obviously it may also have a structure without a movable clamper as shown in FIG. 20 as another example.

The present invention is not limited to the above embodiments, and various modifications are possible within a scope that does not depart from the present invention.

## Claims

1. A forming apparatus of a sealing resin, which is a forming apparatus that tablets a base resin to form a sealing resin to be used for compression molding of a workpiece, the forming apparatus comprising:
a tableting mold that accommodates a particular amount of the base resin in one or both of a pair of a lower mold and an upper mold subjected to mold opening and closing, and tablets the base resin to form the sealing resin having a particular shape corresponding to a shape of the workpiece.

2. The forming apparatus of a sealing resin according to claim 1, wherein
as the workpiece, a workpiece having a configuration in which an electronic component is mounted on a substrate is used, and
the particular shape is a shape that does not abut against the electronic component upon placing the sealing resin onto the substrate.

3. The forming apparatus of a sealing resin according to claim 2, wherein
as the workpiece, a workpiece having a configuration in which an electronic component is mounted on a substrate is used, and
the particular amount is an amount set by measuring a count of presence or absence of the electronic component mounted on one substrate for each workpiece to calculate a resin amount required, or is an amount set by selecting from a plurality of types of standard amounts corresponding to a type of the workpiece.

4. The forming apparatus of a sealing resin according to any one of claims 1 to 3, wherein
a powder resin is used as the base resin.

5. The forming apparatus of a sealing resin according to any one of claims 1 to 3, further comprising:
a lower mold film supply part that supplies and adsorbs a release film to a mold surface of the lower mold; and an upper mold film supply part that supplies and adsorbs a release film to a mold surface of the upper mold.

6. A forming method of a sealing resin, which tablets a base resin to form a sealing resin to be used for compression molding of a workpiece, the forming method comprising:
a tableting process of accommodating and tableting a particular amount of the base resin in a tableting mold, and forming the sealing resin having a particular shape corresponding to a shape of the workpiece.

7. The forming method of a sealing resin according to claim 6, wherein
as the workpiece, a workpiece having a configuration in which an electronic component is mounted on a substrate is used, and
the particular shape is a shape that does not abut against the electronic component upon placing the sealing resin onto the substrate.

8. The forming method of a sealing resin according to claim 7, wherein
as the workpiece, a workpiece having a configuration in which an electronic component is mounted on a substrate is used,
the forming method further comprising:
a resin amount setting process of measuring a count of presence or absence of the electronic component mounted on one substrate for each workpiece to calculate a resin amount required and set the particular amount, or selecting from a plurality of types of standard amounts corresponding to a type of the workpiece to set the particular amount.

9. The forming method of a sealing resin according to any one of claims 6 to 8, wherein
a powder resin is used as the base resin.

10. The forming method of a sealing resin according to any one of claims 6 to
the tableting process is implemented at a temperature at which the base resin does not thermally cure, such that the formed sealing resin is capable of thermally curing in a subsequent resin sealing process.

11. The forming method of a sealing resin according to any one of claims 6 to 8, further comprising, before the tableting process:
a lower mold film supply process of supplying and adsorbing a release film to a mold surface of a lower mold; and an upper mold film supply process of supplying and adsorbing a release film to a mold surface of an upper mold.
